# FASCICULE DE BREVET EUROPEEN

(11) **EP 0 486 398 B1**
(45) Date de publication et mention de la délivrance du brevet: **01.02.1995**
(21) Numéro de dépôt: 91403062.2
(22) Date de dépôt: 14.11.1991
(51) Int. Cl.: H05K 7/14, H05K 9/00

(54) **Embase pour coffret blindé de circuits électroniques**
Unterteil für ein abgeschirmtes Gehäuse mit elektronischen Schaltungen
Base for a shielded electronic circuits box

(30) Priorité: 16.11.1990 FR 9014308
(43) Date de publication de la demande: 20.05.1992
(73) Titulaire: SAT (Société Anonyme de Télécommunications), 75116 Paris (FR)
(72) Inventeur: Michaux, Jean-Pierre, F-75625 Paris Cedex 13 (FR); Roger, Christian Michel, F-75625 Paris Cedex 13 (FR)
(74) Mandataire: Cabinet Martinet & Lapoux

(56) Documents cités:
- EP-A- 0 252 203
- EP-A- 0 351 071
- DE-A- 2 813 812
- GB-A- 1 462 058

## Description

La présente invention concerne une embase pour coffret blindé ayant une enceinte métallique contenant des composants électroniques, de préférence disposées sur cartes imprimées, dite cartes-filles .

L'embase comprend une carte imprimée, dite carte-mère, pour relier les composants à des connecteurs, et un cadre métallique. La carte-mère comporte sur une face externe au moins une plage qui est métallisée à l'extérieur de l'enceinte et qui supporte les connecteurs. Le cadre métallique a des côtés encadrant la carte et un fond formant l'assise du coffret.

Une telle embase peut être déduite de celle du coffret blindé décrit dans le brevet britannique GB-A-1 462 058. La plage métallisée située sur la face externe de la carte-mère est reliée électriquement à l'enceinte grâce à l'application de chants des parois de l'enceinte sur la plage métallisée.

Par contre, la continuité électrique du blindage entre la carte-mère, telle qu'une carte impriméee en matière isolante, n'est assurée que par le contact discontinu de la périphérie de la plage métallisée avec des côtés du cadre métallique perpendiculaires à la carte-mère. En effet, la périphérie de la carte-mère repose dans des encoches pratiquées dans les côtés du cadre métallique, si bien que la plage métallisée n'est pas en contact intime et continu avec le cadre.

La présente invention vise à parfaire le blindage d'une embase pour coffret blindé et particulièrement le blindage à la jonction entre le cadre métallique et la carte-mère.

A cette fin, une embase selon l'invention énoncée dans la revendication 1 pour coffret blindé telle que définie dans l'entrée en matière est caractérisée,
par un joint électrique supporté par les côtés de cadre, et
par une bordure qui est métallisée sur une face interne de la carte, dite carte-mère, qui est reliée électriquement à ladite plage sur la face externe, et qui est appliquée contre ledit joint électrique.

Dans ces conditions, les tolérances de dimension entre le périmètre interne du cadre et le pourtour de la carte-mère peuvent être relativement plus élevées que la précision de dimension et d'ajustage de la carte-mère et du cadre requis par la technique antérieure. Le jeu entre les chants de la carte-mère et les côtés du cadre est ainsi bien toléré notamment lorsque le cadre est en tôle métallique et donc lorsque les côtés du cadre ne sont pas parfaitement perpendiculaires au fond du cadre.

D'autres caractéristiques de l'embase sont énoncées dans les revendications 2 à 9.

En particulier, lorsque l'un des côtés du cadre est sensiblement prolongé par l'un des côtés de l'enceinte, l'invention assure simultanément la continuité électrique entre le cadre, l'enceinte et la plage métallisée sur la face externe de la carte-mère. Dans ce cas, il est prévu un interstice entre un côté du cadre et un chant de la carte en regard dudit côté pour le passage partiel d'une paroi de l'enceinte dont le bord est en contact avec ledit joint électrique.

D'autres avantages de l'invention apparaîtront plus clairement à la lecture de la description suivante de plusieurs réalisations préférées de l'invention en référence aux dessins annexés correspondants dans lesquels :
- la Fig.1 est une vue en perspective d'un coffret blindé comportant une embase selon l'invention, le couvercle du coffret étant en partie arraché;
- la Fig.2 est une vue en coupe verticale transversale d'un coffret analogue à celui montré à la Fig.1, mais comportant des plages métallisées pour connecteurs de part et d'autre de l'enceinte métallique du coffret contenant des cartes imprimées, ces dernières n'étant pas représentées;
- la Fig.3 est une vue de dessus de l'embase du coffret montré à la Fig.2;
- la Fig.4 est une vue en coupe détaillée prise le long de la ligne IV-IV de la Fig.3; et
- la Fig.5 est une vue en coupe détaillée prise le long de la ligne V-V de la Fig.3.

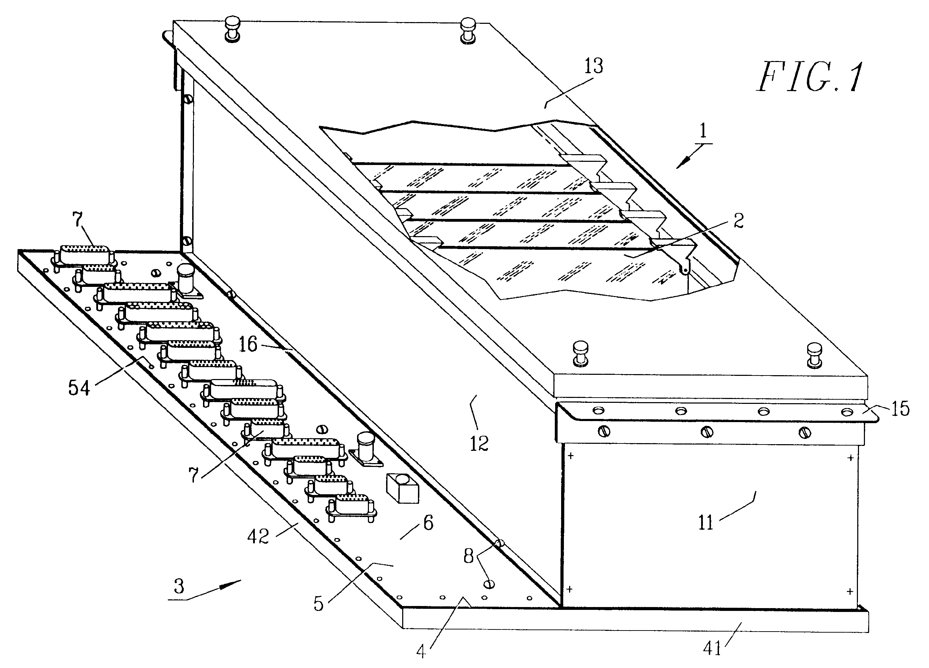

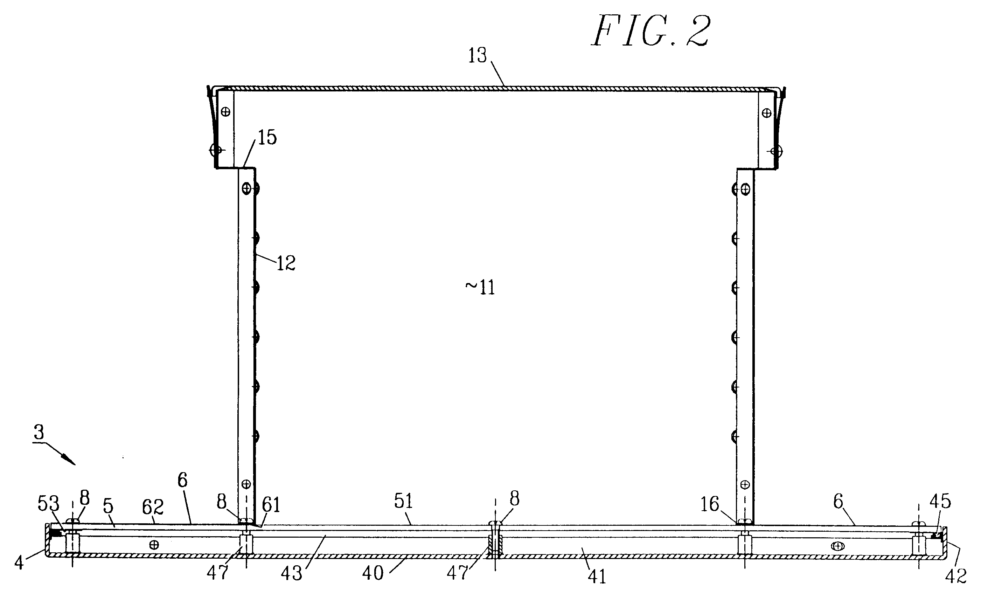

Un coffret métallique blindé 1 peut-être polygonal ou cylindrique, et selon la réalisation préférée montré aux Figs.1 et 2 est sous la forme générale d'un parallélépipède rectangle.

Le coffret contient des circuits intégrés et composants électroniques (non représentés) qui sont disposés de préférence sur l'une et/ou l'autre des faces de plusieurs premières cartes imprimées 2 et qui sont relatifs par exemple à un transmetteur radio. Les cartes 2 sont ici rangées parallèlement à deux petites parois transversales verticales 11 du coffret et glissées chacune dans deux glissières fixées sur les faces internes de deux grandes parois longitudinales verticales 12 du coffret.

Les parois 11 et 12 forment ainsi une couronne rectangulaire dont l'ouverture supérieure est fermée par un couvercle métallique horizontal 13 et dont l'ouverture inférieure est fermée par une embase horizontale 3 selon l'invention, constituant le fond du coffret. La couronne 11-12, le couvercle 13 et un cadre métallique 4 dans l'embase 3 sont réalisés à partir de tôles pliées et soudées. Le couvercle 13 est fixé sur la couronne 11-12 et la couronne est fixée sur l'embase 3 au moyen de vis 8 traversant des rebords d'appui supérieurs 15 et inférieurs 16 sur les pourtours externes des ouvertures de la couronne afin de constituer un coffret complètement fermé, blindé et de préférence hermétique.

Le couvercle 13 peut comporter, sur une face externe, un radiateur de refroidissement à ailettes. Sous une face interne du couvercle 13 peut être prévu un matelas thermoconducteur compressible, de préférence en élastomère et chargé de particules métalliques, afin de constituer à la fois un drain thermique entre les cartes imprimées 2 internes au coffret et l'extérieur, et un moyen pour presser les cartes imprimées contre le fond du coffret et immobiliser celles-ci dans l'enceinte 11-12-13 du coffret.

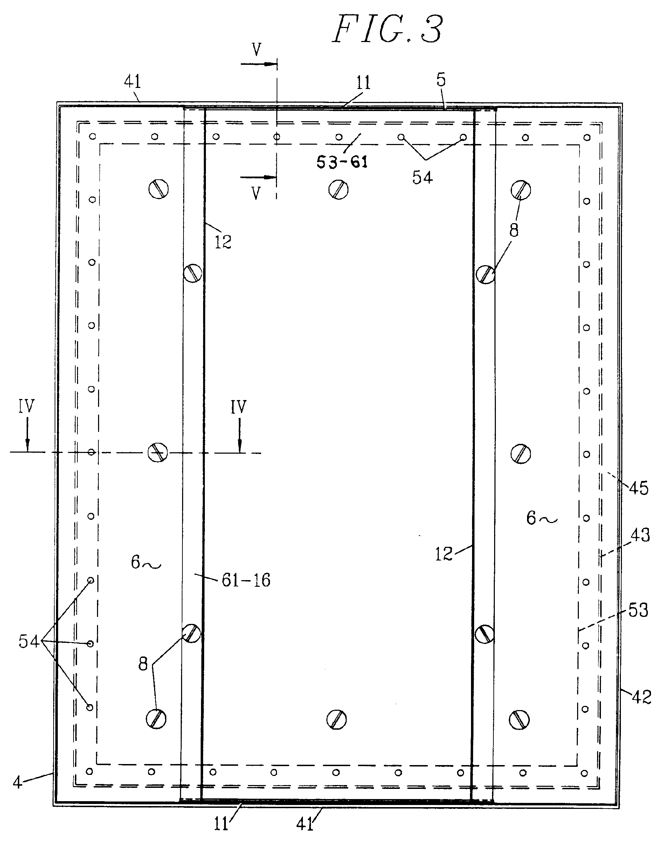

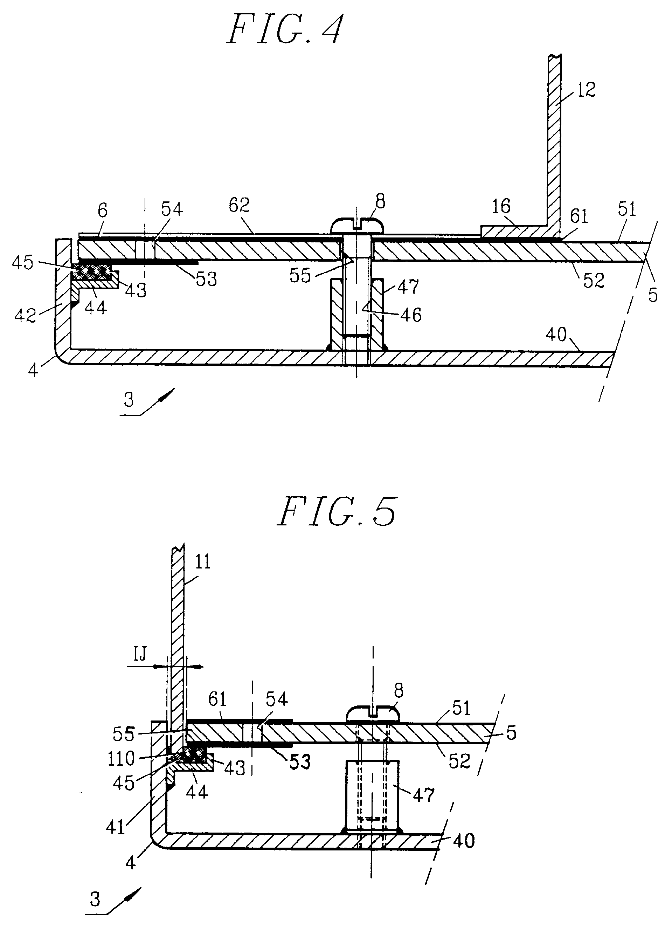

Comme montré plus en détail aux Figs.3 et 4, l'embase de coffret 3 comprend essentiellement le cadre métallique 4 et une seconde carte imprimée 5, appelée carte-mère.

Le cadre 4 est rectangulaire et mince. Il comporte un fond plat 40 nettement plus grand que la section de base, ici horizontale, de la couronne 11-12 du coffret. Le fond 40 forme l'assise du coffret. Quatre côtés verticaux 41 et 42 ayant une hauteur très petite par rapport à celle du coffret sont dressés perpendiculairement au fond 40 par pliage de tôle et sont soudés entre eux dans les encoignures du cadre, éventuellement renforcées par des cornières.

Selon les réalisations illustrées, la longueur du cadre 4 entre les côtés parallèles 41 est sensiblement égale à la longueur de la couronne entre les parois 11, de préférence sensiblement supérieure à la longueur de couronne, comme on le verra dans la suite en référence à la Fig.5; la largeur du cadre 40 entre les côtés parallèles 42 est nettement plus grande que la largeur de la couronne entre les parois 12 afin de ménager une plage 6 montrée à la Fig.1, ou deux plages 6 montrées à la Fig.2, sur l'embase 3 latéralement à l'enceinte 11-12-13 pour y fixer des connecteurs électriques standards 7. Les connecteurs 7 sont destinés à relier des lignes ou bus de transmission externes au coffret, aux cartes imprimées 2 à travers la carte-mère 5.

La carte-mère 5 est une carte imprimée double-face et de préférence multicouche. La face supérieure 51 de la carte-mère externe à l'embase 3 est au moins métallisée complètement en les plages 6 non recouvertes par l'enceinte 11-12-13.

Une bordure latérale rectangulaire 61 des plages 6 est située en dessous des parois longitudinales 12 de la couronne de coffret et, en variante non représentée, est située également en dessous de l'une au moins des parois transversales de couronne 11, lorsque la longueur de la couronne 11-12 est sensiblement plus petite que celle du cadre 4. Plus précisément, la bordure 61 est en contact électrique et mécanique avec les rebords inférieurs 16 de la couronne métallique afin de réaliser une parfaite continuité du blindage entre les plages 6 et l'enceinte 11-12-13 formée par la couronne et le couvercle et contenant les "cartes-filles" 2.

Toutefois, selon une autre variante, la face externe 51 de la carte-mère peut être entièrement métallisée, y compris à l'intérieur de l'enceinte 11-12-13.

Les plages métallisées 6 sont recouvertes de préférence d'une couche isolante 62, telle que résine epoxydique, à l'exception de la bordure 61, notamment lorsque les connecteurs 7 ont des faces inférieures appliquées sur la carte-mère qui sont métalliques.

Plusieurs couches internes de rubans conducteurs (non représentés) s'étendent dans la carte-mère 5 entre les plages 6 et l'enceinte 11-12-13 contenant les "cartes-filles" 2 pour relier des broches des connecteurs 7 à des broches de connecteurs fixés sur des bords inférieurs des cartes 2, à travers des trous pratiqués dans la carte-mère.

La carte-mère 5 a un périmètre semblable à celui du cadre d'embase 4, et présente ici un contour rectangulaire sensiblement plus petit que le périmètre interne délimité par les quatre côtés de cadre 41 et 42, afin que la carte-mère ferme l'ouverture supérieure du cadre 4.

Comme montré en détail à la Fig.4, des petites cornières 43 sont prévues en porte-à-faux sur tout le pourtour interne du cadre 4. Des ailes horizontales 44 des cornières 43 sont rapportées aux faces internes des quatre côtés de cadre 41 et 42 par des cordons de soudure continus. Les cornières 43 supportent un joint électrique de blindage 45, de préférence souple, tel que tresse métallique. Le joint 45 est continu et forme un rectangle fermé. La hauteur du joint 45 est supérieure à l'aile verticale des cornières 43 afin que, lors de l'introduction de la carte-mère dans le cadre 4, le bord périphérique de la face inférieure 52 de la carte-mère repose seulement sur le joint 45, en excellent contact mécanique et électrique avec celui-ci, quels que soient le jeu et les tolérances de dimension entre le pourtour de la carte-mère 5 et le périmètre interne du cadre 4.

La continuité électrique du blindage entre les plages externes métallisées 6 et le joint 45 est assurée par une bordure métallisée rectangulaire 53 imprimée sur le pourtour de la face inférieure 52 de la carte-mère 5 interne à l'embase 3 et par des trous métallisés 54 pratiqués dans la carte-mère et reliant la bordure 53 aux plages 6. Des composants électriques discrets, tels que parafoudres et fusibles, peuvent être fixés à la carte-mère et disposés dans l'espace interne à l'embase, entre la carte-mère 5 et le fond de cadre 40.

La bordure métallisée inférieure 53 est appliquée contre le joint 45 sous une substantielle pression exercée par le vissage de vis à tête fendue 8. Les vis 8 traversent avec jeu des seconds trous lisses 55 menagés dans la carte-mère 5. Dans des trous 46 taraudés dans des petits fûts cylindriques 47 qui sont rapportés par soudage sur la face interne du fond de cadre 40, sont vissées les vis 8 jusqu'à ce que les têtes des via 8 soient appliquées contre la face supérieure 51 de la carte-mère. La hauteur des fûts est inférieure à la distance entre le joint 45, épaisseur de celui-ci comprise, et la face interne du fond de cadre 40, afin que la face inférieure de carte-mère 52 ne soit pas en contact avec les fûts 47 et donc la bordure de blindage 53 s'appuie sur le joint 45. Dans ce cas, le joint 45 est tassé pour adhérer aux cornières 43 et aux côtés de cadre 41 et 42.

Des fûts cylindriques taraudés 47 sont également prévus sous la bordure métallique de plage 61 afin d'y recevoir des vis de fixation 8 des rebords inférieurs 16 de la couronne 11-12.

Selon la variante illustrée à la Fig.5, au moins l'une des parois de l'enceinte du coffret, telle que l'une des parois transversales 11, est disposée au droit de l'interstice de jonction IJ entre le côté correspondant 41 du cadre 4 et le chant correspondant 55 de la carte-mère 5, en regard l'un de l'autre.

Une telle disposition est prévue lorsque l'une 11 des parois de l'enceinte est sensiblement dans le prolongement de l'un 41 des côtés du cadre, notamment lorsque la longueur de l'enceinte 11-12-13 entre les parois transversales 11 est sensiblement égale, et plus précisément sensiblement inférieure, à celle du cadre 4. Dans cette variante, ledit interstice IJ a une largeur sensiblement égale à l'épaisseur de la paroi 11. La hauteur de la paroi 11 est plus grande que celle des parois 12 à rebords 16, et excède celle-ci d'une longueur supérieure à l'épaisseur de la carte-mère 5 mais inférieure à la distance entre la face externe 51 de la carte-mère et les ailes 44 des cornières 43 supportant le joint électrique 5. Le bord inférieur 110 de la paroi 11 est sensiblement coincé entre le cadre 4 et la carte-mère 5, et est en contact mécanique et électrique avec le joint électrique 45, ce qui améliore le blindage.

Dans ces conditions, le coffret 1 constitue une véritable cage de Faraday dont la continuité électrique de blindage est parfaitement assurée entre les parois 11 et 12 de l'enceinte contenant les cartes-filles 2 et le cadre 4 de l'embase 3 à travers les plages 6, les trous 54, la bordure 53, et le joint 45 et les cornières 43, tout en permettant des démontages et accessibilité aisés de la carte-mère 5 supportant les connecteurs externes 7.

## Revendications

1. Embase pour coffret blindé (1) ayant une enceinte métallique (11-12-13) contenant des composants électroniques (2),
ladite embase (3) comprenant une carte imprimée (5) pour relier lesdites composants (2) à des connecteurs (7), et un cadre métallique (4),
ladite carte (5) comportant sur une face externe (51) au moins une plage (6) qui est métallisée et se trouve à l'extérieur de ladite enceinte (11-12-13) et qui supporte lesdits connecteurs (7), et
ledit cadre métallique (4) ayant des côtés encadrant la carte (5) et un fond (40) formant l'assise du coffret (1),
caractérisée par un joint électrique (45) supporté par les côtés de cadre (41,42), et par une bordure (53) qui est métallisée sur une face interne (52) de la carte (5), qui est reliée électriquement à ladite plage (6) sur la face externe, et qui est appliquée contre ledit joint électrique (45).

2. Embase conforme à la revendication 1, caractérisée en ce que le joint électrique (45) est une tresse métallique.

3. Embase conforme à la revendication 1 ou 2, caractérisée en ce qu'elle comprend des cornières métalliques (43) rapportées contre des faces internes des côtés (41,42) du cadre (4) et supportant le joint électrique (45).

4. Embase conforme à l'une quelconque des revendications 1 à 3, caractérisée par des trous métallisés (54) pratiqués dans la carte (5) et reliant la plage (6) sur la face externe de la carte à la bordure (53) sur la face interne de la carte.

5. Embase conforme à l'une quelconque des revendications 1 à 4, caractérisée par des fûts taraudés (47) dressés sur le fond de cadre (40) pour recevoir des vis (8) traversant la carte (5) et immobilisant la carte sur ledit joint électrique (45).

6. Embase conforme à l'une quelconque des revendications 1 à 5 caractérisée par une face externe (51) de la carte (5) entièrement métallisée.

7. Embase conforme à l'une quelconque des revendications 1 à 6, caractérisée par une couche isolante (62) recouvrant au moins la plage métallisée de face externe (6) à l'extérieur de ladite enceinte (11-12-13).

8. Embase conforme à l'une quelconque des revendications 1 à 7, caractérisée par une bordure interne (61) de la plage de face externe (6) en contact électrique et mécanique avec des rebords (16) de l'enceinte (11-12-13).

9. Embase conforme à l'une quelconque des revendications 1 à 8, caractérisé par un interstice (IJ) entre un côté (41) du cadre (4) et un chant (55) de la carte (5) en regard dudit côté (41) pour le passage partiel d'une paroi (11) de l'enceinte dont le bord (110) est en contact avec ledit joint électrique (45).

## Patentansprüche

1. Unterteil für ein abgeschirmtes Gehäuse (1), aufweisend einen metallischen Behälter (11-12-13), der elektronische Bauteile (2) enthält,
- wobei das Unterteil (3) eine Leiterplatte (5) zur Verbindung der Bauteile (2) mit Verbindungsmitteln (7) und einen metallischen Rahmen (4) umfaßt,
- wobei die Karte (5) auf einer Außenseite (51) wenigstens einen Bereich (6) aufweist, der metallisiert ist und sich auf der Außenseite des Behälters (11-12-13) befindet und der die Verbindungsmittel (7) trägt, und
- wobei der metallische Rahmen (4) die Karte (5) einrahmende Seiten und einen die Grundplatte des Gehäuses bildenden Boden (40) umfaßt,
**gekennzeichnet** durch eine elektrische Verbindung (45), die durch die Rahmenseiten (41, 42) gehaltert ist, und durch eine Einfassung (53), die auf einer Innenseite (52) der Karte (5) metallisiert ist, die elektrisch mit dem Bereich (6) auf der Außenseite verbunden ist und die gegen die elektrische Verbindung (45) angelegt ist.

2. Unterteil nach Anspruch 1, dadurch **gekennzeichnet**, daß die elektrische Verbindung (45) ein Metallgeflecht ist.

3. Unterteil nach Anspruch 2 oder 3, dadurch **gekennzeichnet**, daß es Metallwinkel (43) umfaßt, die gegen die Innenseiten der Seiten (41, 42) des Rahmens (4) aufgesetzt sind und die elektrische Verbindung (45) haltern.

4. Unterteil nach einem beliebigen der Ansprüche 1 bis 3, **gekennzeichnet** durch metallisierte Löcher (54), die in der Karte (5) ausgeführt sind und die den Bereich (6) auf der Außenseite der Karte mit der Einfassung (53) auf der Innenseite der Karte verbinden.

5. Unterteil nach einem beliebigen der Ansprüche 1 bis 4, **gekennzeichnet** durch mit Innengewinde versehene Hülsen, die auf dem Boden des Rahmens (40) ausgeführt sind, um die Karte (5) durchquerende Schrauben (8) aufzunehmen, und die die Karte auf der elektrischen Verbindung (45) festhalten.

6. Unterteil nach einem beliebigen der Ansprüche 1 bis 5, **gekennzeichnet** durch eine völlig metallisierte Außenseite (51) der Karte (5).

7. Unterteil nach einem beliebigen der Ansprüche 1 bis 6, **gekennzeichnet** durch eine Isolierschicht (62), die wenigstens den metallisierten Außenseitenbereich (6) bis zur Außenseite des Behälters (11, 12-13) überdeckt.

8. Unterteil nach einem beliebigen der Ansprüche 1 bis 7, **gekennzeichnet** durch eine Inneneinfassung (61) des Außenseitenbereichs (6) im elektrischen und mechanischen Kontakt mit Randbereichen (16) des Gehäuses (11-12-13).

9. Unterteil nach einem beliebigen der Ansprüche 1 bis 8, **gekennzeichnet** durch einen Zwischenraum (IJ) zwischen einer Seite (41) des Rahmens (4) und einer Kante (55) der Karte (5) gegenüber der Seite (41) für das teilweise Hindurchtreten einer Wand (11) des Gehäuses, deren Rand (110) sich in Kontakt mit der elektrischen Verbindung (45) befindet.

## Claims

1. A base unit for a screened box (1) having a metal enclosure (11, 12, 13) containing electronic components (2),
the base unit (3) comprising a printed circuit board (5) for connecting the components (2) to connectors (7), and a metal frame (4),
the board (5) comprising on an outside surface (51) at least one zone (6) which is metalised, is disposed outside the enclosure (11, 12, 13) and carries the connectors (7),
the metal frame (4) having sides framing the board (5) and a base (40) serving as the box seat,
characterised by an electrical joint (45) carried by the frame sides (41, 42) and by an edging (53) which is metalised on an inside surface (52) of the board (5), is electrically connected to the zone (6) on the outside surface and is in engagement with the electrical joint (45).

2. A base unit according to claim 1, characterised in that the electrical joint (45) is a metal braiding.

3. A base unit according to claim 1 or 2, characterised in that it comprises metal angle members (43) secured to inside surfaces of the frame sides (41, 42) and carrying the electrical joint (45).

4. A base unit according to any of claims 1 to 3, characterised by metalised apertures (54) in the board (5) which connect the zone (6) on the outside surface of the board to the edging (53) on the inside surface of the board.

5. A base unit according to any of claims 1 to 4, characterised by tapped pillars (47) standing on the frame base (40) to receive screws (8) which extend through the board (5) and immobilise the same on the electrical joint (45).

6. A base unit according to any of claims 1 to 5, characterised by a completely metalised outside surface (51) of the board (5).

7. A base unit according to any of claims 1 to 6, characterised by an insulating layer (62) covering at least the metalised zone (6) of the outside surface outside the enclosure (11, 12, 13).

8. A base unit according to any of claims 1 to 7, characterised by an inside edge (61) of the outside surface zone (6) in electrical and mechanical contact with angle members (16) of the enclosure (11, 12, 13).

9. A base unit according to any of claims 1 to 8, characterised by a gap (IJ) between a side (41) of the frame (4) and an edge (55) of the board (5) facing the latter side (41), such gap serving for the partial passage of an enclosure wall (11) whose edge (110) is in contact with the electrical joint (45).
